# EUROPÄISCHE PATENTSCHRIFT

(11) **EP 0 390 076 B1**
(45) Veröffentlichungstag und Bekanntmachung des Hinweises auf die Patenterteilung: **07.09.1994**
(21) Anmeldenummer: 90105821.4
(22) Anmeldetag: 27.03.1990
(51) Int. Cl.: H03H 11/12

(54) **Integrierbare Filterschaltung mit Bandpassverhalten**
Integratable band-pass filter
Filtre passe-bande pouvant être constitué sous forme de circuit intégré

(30) Priorität: 30.03.1989 EP 89105643
(43) Veröffentlichungstag der Anmeldung: 03.10.1990
(73) Patentinhaber: SIEMENS AKTIENGESELLSCHAFT, 80333 München (DE)
(72) Erfinder: Bichler, Helmut, Ing., D-8032 Gräfelfing (DE)

(56) Entgegenhaltungen:
- EP-A- 0 013 943
- EP-A- 0 274 784
- US-A- 3 501 709
- US-A- 3 529 256

## Beschreibung

Die Erfindung betrifft eine Filterschaltung mit Bandpaßverhalten
- mit einer Verstärkerschaltung mit einem Eingang, einem Gegenkopplungseingang und einem Ausgang,
- mit einem Gegenkopplungsnetzwerk mit einer ersten Kapazität und einem Widerstand, das zwischen den Ausgang und einen der Eingänge der Verstärkerschaltung geschaltet ist.

Integrierte Schaltkreise für die analoge Signalverarbeitung beinhalten oft Filterschaltungen, um unerwünschte Störgrößen zu unterdrücken. Sehr häufig finden dabei Bandpässe Verwendung, beispielsweise zum Ausfiltern von schmalbandigen Nutzsignalen aus breitbandigen Störsignalen. Die Filterschaltungen sind dabei bevorzugt so ausgelegt, daß zur Mittenfrequenzeinstellung ein möglichst geringer externer Beschaltungsaufwand nötig ist. Da geeignete Kapazitäten und Induktivitäten bisher nur sehr schwierig bzw. überhaupt nicht in integrierter Technik realisierbar sind, werden üblicherweise externe Elemente insbesondere Kondensatoren als Elemente zur Mittenfrequenzeinstellung eingesetzt.

Beispielsweise aus U. Tietze-Ch. Schenk, Halbleiterschaltungstechnik, 5. Auflage 1980, Seite 307 ff, sind Bandpässe mit einem aus zwei Widerständen und zwei Kondensatoren bestehenden Netzwerk in der Rückkopplungsschleife eines Operationsverstärkers bekannt, wobei maximal einer der beiden Kondensatoren auf das Bezugspotential geführt ist. Da der Operationsverstärker sowie die beiden Widerstände in integrierter Technik realisierbar sind, müssen lediglich die beiden Kondensatoren extern dazugeschaltet werden. Dazu sind aber bei dem in Frage kommenden Schaltkreis mindestens drei weitere Anschlüsse vorzusehen.

Die in der US-Patentschrift 3 529 256 gezeigte Bandpaßschaltung enthält einen Differenzverstärker hoher Verstärkung, dessen Ausgang über ein Kerbfilter auf den Eingang rückgekoppelt ist. Der Gegentakteingang des Differenzverstärkers ist mit einer Konstantspannungsquelle verbunden. Die Schaltung enthält eine Vielzahl von Bauelementen. Insbesondere das Kerbfilter weist drei Kondensatorstufen auf, deren Realisierung als integrierte Schaltung einen hohen Flächenbedarf erfordert.

Aufgabe der Erfindung ist es daher, eine Filterschaltung mit Bandpaßverhalten anzugeben, die mit einer möglichst geringen Zahl von Elementen realisierbar ist.

Diese Aufgabe wird bei einer gattungsgemäßen Filterschaltung dadurch gelöst, daß
- der Ausgang der Verstärkerschaltung ein stromeinprägender Ausgang ist,
- der Ausgang der Verstärkerschaltung mit einem Knotenpunkt verbunden ist,
- ein Ausgang der Filterschaltung mit dem Knotenpunkt verbunden ist,
- eine zweite Kapazität zwischen den Knotenpunkt und ein Bezugspotential geschaltet ist,
- der Widerstand des Gegenkopplungsnetzwerks zwischen den Knotenpunkt und den Gegenkopplungseingang der Verstärkerschaltung geschaltet ist und
- die erste Kapazität des Gegenkopplungsnetzwerks zwischen den Gegenkopplungseingang der Verstärkerschaltung und Bezugspotential geschaltet ist.

Ausgestaltungen und Weiterbildungen des Erfindungsgedankens sind in Unteransprüchen gekennzeichnet.

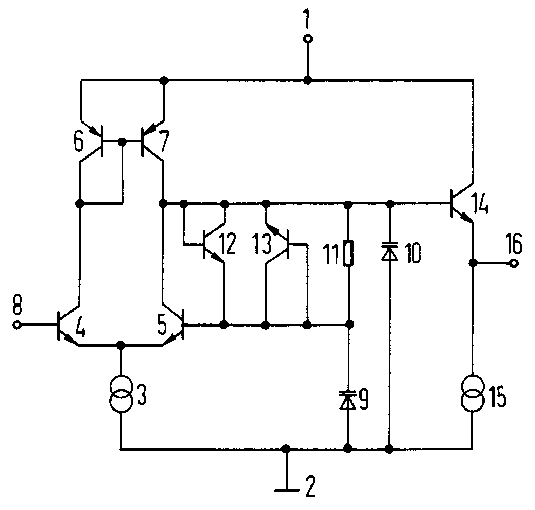

Die Erfindung wird nachfolgend anhand des in der einzigen Figur der Zeichnung dargestellten Ausführungsbeispiels näher erläutert.

Das Ausführungsbeispiel gemäß der Zeichnung umfaßt einen Differenzverstärker 3 bis 7 mit zwei NPN-Transistoren 4, 5, deren Kollektoren jeweils über einen Stromzweig eines Stromspiegels 6, 7 auf ein Versorgungspotential 1 und deren gekoppelte Emitter über eine Stromquelle 3 auf Bezugspotential 2 geführt sind. Ein PNP-Transistor 6 ist den Eingangszweig 2 des Stromspiegels 6, 7 bildend über seinen Emitter mit dem Versorgungspotential 1 verbunden und über Basis und Kollektor, mit dem Kollektor des Transistors 4 verschaltet, dessen Basis als nichtinvertierender Eingang 8 des Differenzverstärkers 3 bis 7 vorgesehen ist. Der Ausgangsstromzweig des Stromspiegels 6, 7 ist durch einen emitterseitig an dem Versorgungspotential 1 liegenden PNP-Transistor 7 gegeben, dessen Basis mit der Basis des Transistors 6 und dessen Kollektor mit dem Kollektor des Transistors 5 verbunden ist. Zwischen Kollektor und Basis des Transistors 5, die als Ausgang bzw. invertierender Eingang des Differenzverstärkers 3 bis 7 vorgesehen sind, ist ein Widerstand 11 geschaltet. Zudem ist von der Basis des Transistors 5 aus eine Kapazitätsdiode 9 und von dem Kollektor aus eine weitere Kapazitätsdiode 10 gegen das Bezugspotential 2 geführt. Dem Kollektor des Transistors 5 ist ein Emitterfolger mit einem NPN-Transistor 14 nachgeschaltet, dessen Emitter den Ausgang 16 bildend über eine Stromquelle 15 an dem Bezugspotential 2 angeschlossen und dessen Kollektor mit dem Versorgungspotential 1 beaufschlagt ist. Zwischen Basis und Kollektor des Transistors 5 sind darüber hinaus zwei jeweils durch Verbinden von Basis und Kollektor als Dioden betriebene und zueinander antiparallel geschaltete NPN-Transistoren 12, 13 vorgesehen.

Die Funktionsweise einer erfindungsgemäßen Filterschaltung beruht darauf, daß ein aus jeweils einer Kapazität 9, 10 in den beiden Querzweigen und aus einem Widerstand 11 im Längszweig bestehendes π-Glied eingangsseitig mit einer Stromansteuerung betrieben wird. Zur Stromansteuerung eignen sich beispielsweise alle Arten von durch ein Eingangssignal steuerbaren Stromquellen. Durch die Stromansteuerung auf den eingangsseitigen Querzweig des π-Gliedes ergibt sich eine Abhängigkeit von der Frequenz des Eingangssignales dergestalt, daß die in diesem Querzweig liegende Kapazität, im vorliegenden Ausführungsbeispiel die Kapazitätsdiode 9, bei tiefen Frequenzen eine größere und bei hohen Frequenzen eine niedrigere Impedanz aufweist. Deshalb ist die an dieser Kapazität abfallende Spannung in Bezug auf das Eingangssignal bei hohen Frequenzen kleiner als bei niedrigen - es ergibt sich also Tiefpaßverhalten. Mit der an dieser Kapazität auftretenden Spannung ist der nachgeschaltete, das Gegenkopplungsnetzwerk der steuerbaren Stromquelle bildenden RC-Tiefpaß, bestehend aus dem Widerstand im Längszweig, nämlich Widerstand 11, und der Kapazität im ausgangsseitigen Querzweig, nämlich die Kapazitätsdiode 10, beaufschlagt. Dieser RC-Tiefpaß liegt jedoch in dem Gegenkopplungszweig der steuerbaren Stromquelle und wirkt daher als Hochpaß. Durch das Zusammenwirken von Hochpaß- und Tiefpaßverhalten der einzelnen Zweige des π-Gliedes ergibt sich insgesamt Bandpaßverhalten.

Als steuerbare Stromquelle ist im vorliegenden Ausführungsbeispiel ein Differenzverstärker 3 bis 7 vorgesehen, dessen Ausgangskreise einen Stromspiegel 6, 7 enthalten. Diese Ausgestaltung bringt den Vorteil eines geringen schaltungstechnischen Aufwandes mit sich.

In Ausgestaltung der Erfindung sind desweiteren als Kapazitäten die mitintegrierbaren Kapazitätsdioden 9 und 10 vorgesehen, die sich vorteilhafterweise aufgrund dessen, daß beide Kapazitäten auf Bezugspotential 2 geführt sind, leicht realisieren lassen und in dem übrigen Schaltkreis auftretende parasitäre Kapazitäten einen nur sehr geringen Einfluß auf die Filterschaltung haben. Dadurch werden keine externe Kondensatoren und damit keine zusätzlichen Anschlüsse bei der integrierten Schaltung mehr benötigt.

Weiterhin sind die Erfindung weiterbildend zwischen Kollektor und Basis des Transistors 5 zwei antiparallel zueinandergeschaltete Dioden vorgesehen. Diese sind bei dem gezeigten Ausführungsbeispiel durch die beiden entsprechend betriebenen Transistoren 11 und 13 gegeben. Die Dioden erhöhen vorteilhafterweise die Übersteuerungsfestigkeit der Filterschaltung.

Die nachgeschaltete Ausgangsstufe mit dem Transistor 14 und der Stromquelle 15 findet bevorzugt dann Anwendung, wenn die am Ausgang 16 anliegende Last eine hohe oder schwankende Eigenkapazität aufweist. Der Vorteil dabei ist, daß Rückwirkungen der Lastkapazität auf das π-Glied geringgehalten werden.

Abschließend sei bemerkt, daß auch weitere Ausführungsformen der Ausgangsstufe möglich sind, sofern dadurch eine Entkopplung von Filterkreis und Lastkreis erzielt wird. Ebenso sind aber auch unterschiedliche Ausführungsformen der steuerbaren Stromquelle anwendbar, wie beispielsweise eine invertierende steuerbare Stromquelle, bei der das Gegenkopplungsnetzwerk dann auf einen gemeinsamen Eingang der Stromquelle geführt ist. Darüber hinaus sind weiter Ausgestaltungen der Kapazitäten neben der Realisierung mit internen Kapazitätsdioden oder entfernen Kondensatoren im Sinne des Erfindungsgedankens.

## Patentansprüche

1. Integrierte Filterschaltung mit Bandpaßverhalten
- mit einer Verstärkerschaltung (3...7) mit einem Eingang (8), einem Gegenkopplungseingang und einem Ausgang,
- mit einem Gegenkopplungsnetzwerk (9, 11) mit einer ersten Kapazität (9) und einem Widerstand (11), das zwischen den Ausgang und einen der Eingänge der Verstärkerschaltung (3...7) geschaltet ist,
**dadurch gekennzeichnet**, daß
- der Ausgang der Verstärkerschaltung (3...7) ein stromeinprägender Ausgang ist,
- der Ausgang der Verstärkerschaltung (3...7) mit einem Knotenpunkt verbunden ist,
- ein Ausgang der Filterschaltung mit dem Knotenpunkt verbunden ist,
- eine zweite Kapazität (10) zwischen den Knotenpunkt und ein Bezugspotential (2) geschaltet ist,
- der Widerstand (11) des Gegenkopplungsnetzwerks (9, 11) zwischen den Knotenpunkt und den Gegenkopplungseingang der Verstärkerschaltung (3...7) geschaltet ist und
- die erste Kapazität (9) des Gegenkopplungsnetzwerks (9, 11) zwischen den Gegenkopplungseingang der Verstärkerschaltung (3...7) und Bezugspotential (2) geschaltet ist.

2. Integrierbare Filterschaltung nach Anspruch 1,
**dadurch gekennzeichnet**, daß als Verstärkerschaltung (3...7) ein Differenzverstärker (3 bis 7) mit Stromausgang vorgesehen ist.

3. Integrierbare Filterschaltung nach Anspruch 1 oder 2,
**dadurch gekennzeichnet**, daß als Kapazitäten integrierbare Kapazitätsdioden (9, 10) vorgesehen sind.

4. Integrierbare Filterschaltung nach einem der Ansprüche 1 bis 3,
**gekennzeichnet durch** zwei zueinander antiparallel und zu dem Widerstand (11) des Gegenkopplungsnetzwerks (9, 11) parallel geschaltete Dioden (12, 13).

5. Integrierbare Filterschaltung nach einem der Ansprüche 1 bis 4,
**gekennzeichnet durch** eine der zweiten Kapazität (10) nachgeschaltete Ausgangsstufe (14, 15).

## Claims

1. Integrated filter circuit having a bandpass characteristic
- having an amplifier circuit (3...7) with an input (8), a negative feedback input, and an output,
- having a negative feedback network (9, 11) with a first capacitance (9) and a resistor (11), which network is connected between the output and one of the inputs of the amplifier circuit (3...7),
characterized in that
- the output of the amplifier circuit (3...7) is a constant-current output,
- the output of the amplifier circuit (3...7) is connected to a node,
- an output of the filter circuit is connected to the node,
- a second capacitance (10) is connected between the node and a reference potential (2),
- the resistor (11) of the negative feedback network (9, 11) is connected between the node and the negative feedback input of the amplifier circuit (3...7) and
- the first capacitance (9) of the negative feedback network (9, 11) is connected between the negative feedback input of the amplifier circuit (3...7) and the reference potential (2).

2. Integrable filter circuit according to Claim 1, characterized in that a differential amplifier (3 to 7) having a current output is provided as the amplifier circuit (3...7).

3. Integrable filter circuit according to Claim 1 or 2, characterized in that integrable variable capacitance diodes (9, 10) are provided as capacitances.

4. Integrable filter circuit according to one of Claims 1 to 3, characterized by two diodes (12, 13) which are connected to each other in reverse-parallel and in parallel with the resistor (11) of the negative feedback network (9, 11).

5. Integrable filter circuit according to one of Claims 1 to 4, characterized by an output stage (14, 15) connected downstream from the second capacitance (10).

## Revendications

1. Circuit intégré de filtrage de type passe-bande
- comportant un circuit (3...7) amplificateur ayant une entrée (8), une entrée de contre-réaction et une sortie,
- comportant un circuit (9, 11) de contre-réaction, qui comprend une première capacité (9) et une résistance (11) et est branché entre la sortie et l'une des entrées du circuit (3...7) amplificateur,
caractérisé en ce que
- la sortie du circuit (3...7) amplificateur est une sortie source de courant,
- la sortie du circuit (3...7) amplificateur est reliée à un noeud,
- une sortie du circuit de filtrage est reliée au noeud,
- une deuxième capacité (10) est branchée entre le noeud et un potentiel (2) de référence,
- la résistance (11) du circuit (9, 11) de contre-réaction est branchée entre le noeud et l'entrée de contre-réaction du circuit (3...7) amplificateur et
- la première capacité (9) du circuit (9, 11) de contre-réaction est branchée entre l'entrée de contre-réaction du circuit (3...7) amplificateur et le potentiel (2) de référence.

2. Circuit intégrable de filtrage suivant la revendication 1,
caractérisé en ce qu'il est prévu comme circuit (3...7) amplificateur un amplificateur (3 à 7) différentiel à sortie en courant.

3. Circuit intégrable de filtrage suivant les revendications 1 ou 2, caractérisé en ce qu'il est prévu comme capacités des diodes (9, 10) à capacité variable, que l'on peut intégrer.

4. Circuit intégrable de filtrage suivant l'une des revendications 1 à 3, caractérisé par deux diodes (12, 13) branchées tête-bêche et en parallèle à la résistance (11 ) du circuit (9, 11 ) de contre-réaction.

5. Circuit intégrable de filtrage suivant l'une des revendications 1 à 4, caractérisé par un étage (14, 15) de sortie branché en aval de la deuxième capacité (10).
